# EUROPEAN PATENT SPECIFICATION

(11) **EP 1 865 552 B1**
(45) Date of publication and mention of the grant of the patent: **15.06.2022**
(21) Application number: 06715588.7
(22) Date of filing: 13.03.2006
(51) Int. Cl.: H01L 23/36, C01B 32/225, H01L 23/373

(54) **HEAT TRANSFER SHEET, RADIATION STRUCTURE AND METHOD FOR USING HEAT TRANSFER SHEET**
WÄRMETRANSFERBLATT, STRAHLUNGSSTRUKTUR UND VERFAHREN ZUR VERWENDUNG EINES WÄRMETRANSFERBLATTS
FEUILLE DE TRANSFERT THERMIQUE, STRUCTURE DE RAYONNEMENT ET PROCEDE D UTILISATION DE FEUILLE DE TRANSFERT THERMIQUE

(30) Priority: 31.03.2005 JP 2005100622
(43) Date of publication of application: 12.12.2007
(73) Proprietor: TOYO TANSO CO., LTD., Osaka-shi, Osaka 555-0011 (JP)
(72) Inventor: HIROSE, Yoshiaki c/o Toyo Tanso Co., Ltd., Mitoyo-shi, Kagawa; 7691102 (JP)
(74) Representative: Wagner & Geyer
(86) International application number: PCT/JP2006/304865
(87) International publication number: WO 2006/112211

(56) References cited:
- EP-A- 0 747 615
- EP-A- 1 120 378
- EP-A2- 1 512 933
- WO-A2-01/63983
- DE-A1- 3 247 534
- JP-A- 2 088 415
- JP-A- 2000 169 125
- JP-A- 2000 169 125
- JP-A- 2004 363 432
- JP-A- 2004 363 432
- US-A- 3 404 061
- US-A- 3 414 381
- US-A- 3 494 382
- US-A- 4 244 934
- US-A- 5 503 717
- US-A- 5 846 459

## Description

### Technical Field

This invention relates to a heat-transfer system. Radiators such as heat sinks are used to cool heat generators such as CPUs of computers, etc. If a radiator does not come into close contact with a heat generator, thermal conductivity from the heat generator to the radiator is low and the heat generator is not cooled sufficiently. Accordingly, usually disposed between such a heat generator and such a radiator is a sheet which has a high thermal conductivity and comes into close contact with the heat generator and the radiator.

This invention relates to a heat transfer system comprising a heat generator, a heat absorber/dissipator, and a heat-transfer sheet.

### Background Art

Graphite sheets are usually used as heat-transfer sheets which are caught between such heat generators and radiators. A graphite sheet is caught and compressed between a heat generator and a radiator; therefore, the graphite sheet comes into close contact with the heat generator and the radiator, reducing the thermal resistance of contact surfaces and, thereby, raising the cooling efficiency.

The pressure applied to the graphite sheet depends on the force securing the heat sink to the heat generator. If large force is applied to a CPU, it may be deformed. Accordingly, a force securing heat sinks to heat generators has been reduced from 5 MPa or so to as small as 2 MPa. If the force securing a heat sink to a heat generator is small, the graphite sheet therebetween does not come into close contact with the heat generator or the heat sink, raising the thermal resistance and, thereby, reducing the cooling efficiency.

To solve the above problem, JP 2004-363432 A discloses a heat-transfer sheet comprising (i) a substance which is liquid at normal temperature and whose phase does not change at the temperature range wherein it is used and (ii) a graphite sheet. Because the liquid in the graphite sheet can move freely, the graphite sheet is disposed in minute concave areas, or recesses, and the liquid accumulates in relatively large concave areas of 5-100 µm in the surfaces of the heat generator and the heat sink if the force securing a heat sink to a heat generator is small. Thus, gaps are prevented from being formed between the heat-transfer sheet and the heat generator and between the heat-transfer sheet and the heat sink and, hence, the thermal resistance is minimized and the heat generator is well cooled.

However, because the liquid exists in the graphite sheet, the heat-transfer sheet is not compressed very well, namely, it does not come into close contact with the heat generator or the heat sink; therefore, the thermal resistance is not low enough.

Besides, the production of the heat-transfer sheet requires a step of impregnating the graphite sheet with the liquid. Accordingly, it cannot be produced relatively efficiently, its production cost is relatively high, the liquid may deteriorate, and nearby components may be polluted by liquid coming out of the graphite sheet.

In order to provide a graphite sheet having high mechanical strengths and further improved characteristics, especially anisotropy in thermal conductivity, JP 2000-169125 A proposes that the sheet-shaped graphite material is constituted of graphite parts and gaseous parts and has a density of 0.1-0.9 g/cm³ and thermal anisotropy such that the thermal conductivity in the direction parallel to the surface is at least 200 times of the thermal conductivity in the direction perpendicular to the surface. In the method for producing the graphite material, which is comprised of heat treating a polymer material in the form of sheet under an inert atmosphere to obtain a graphitized carbon film, heating in a temperature range of 400-800 °C is carried out with a temperature raising rate of 1-10 °C/min, and the polymer material is finally heated at least up to 2,400 °C.

EP 1 512 933 A2 discloses a light-weight heat conduction plate consisting of expanded and subsequently compressed graphite without bonding agents. Its heat conductivity parallel to the plate surfaces is at least 50 % higher than that perpendicular to theses surfaces. Also disclosed are (a) a combination of two light-weight heat conduction plates; (b) a compound building element with at least one light-weight heat conduction plate; (c) an application of light-weight heat conduction plates or compound building elements for floor, wall or ceiling heating, for heat transfer and removal in automobiles and the like; (d) a method for producing a light-weight heat conduction plate.

US 3,494,382 A discloses a flexible graphite web, produced by compressing graphite which has previously been expanded in a preferred direction may be coated with metals, e.g. Al, Ag, Au or Cu, carbides or oxides by known techniques. The object thereof is to provide flexible graphite web material and articles or products made of same, and in general, only discloses basic composition and manufacturing method of expanded graphite, not suggesting improving adhesion by a low bulk density of expanded graphite as in the present invention. Sides or surfaces of the flexible graphite web material can be embossed, quilted, or otherwise provided with a pattern and can be coated with a suitable material, for example metal such as aluminum, gold, silver or copper to provide wear resistance, additional strength or the like, and also, can be provided with an adhesive or with a suitable backing or carrier material to provide additional strength thereto.

US 5,846,459 A discloses that a flexible graphite sheet is made by compressing a mixture of relatively large particles of intercalated, exfoliated, expanded natural graphite with smaller particles of intercalated, exfoliated expanded, expanded particles of natural graphite. The resulting sheet of flexible graphite exhibits increased electrical conductivity through the thickness ("c" direction) of the sheet and improved sealability perpendicular to the "c" direction.

DE 32 47 534 A1 discloses thin broad-area thermally-conductive mountings built up from layers of a special form of substantially pure flexible and compressible flat graphite sheet material and a bonding-and-filling coating. At least one such 5-10 mil thickness layer of Grafoil flexible sheet, involving a crushable compressed mass of expanded graphite particles which are plate-like and oriented essentially parallel with the sheet surfaces, is intimately connected with a very thin bonding-and-filling coating substantially fully along its broad-area surfaces, and the latter coating is bonded at elevated temperature and pressure into a self-adhering relationship with surfaces of a heat-sink device intended to be disposed opposite surfaces of an electronic semiconductor device from which excess heat is to escape. The coating is applied while in a liquid condition, in quantity sufficient to be effective to fill minute interstitial spaces appearing along the heat-sink surfaces and yet not so thickly as to prevent numerous point contacts from being made at sites of minute surface irregularities of the graphite sheet material and the heat-sink device. Mechanical fastening of a semiconductor device atop the prepared mounting layers of the heat-sink device compresses the crushable graphite sheet material so that voids are minimized and low thermal impedance can be realized between the heat sink and semiconductor device.

US 5,503717 A discloses ZnCl₂-graphite intercalation compound synthesised by an electrochemical process in an aqueous solution. Flexible graphite is manufactured by exfoliating and then compressing the ZnCl₂-graphite intercalation compound into a sheet form.

### Disclosure of Invention

### Problems that the Invention is to solve

Accordingly, the object of the present invention is to provide a heat transfer system comprising a heat generator, a heat absorber/dissipator, and a heat-transfer sheet.

### Means of solving the Problems

According to the present invention, there is provided a heat-transfer system as set forth in claim 1.

The compressibility of the heat-transfer sheet is 50% or more and its recovery is 5% or more when it is thicknesswise compressed by a pressure of 34.3 MPa.

Further, the bulk density of the heat-transfer sheet is less than 0.9 Mg/m³, and the heat-transfer sheet is compressed by a pressure of 1.5 MPa or less.

The heat absorber/dissipator according to the present invention, hereinafter also referred to as "radiator", includes devices with the function of dissipating the heat of heat-transfer sheets to gas, liquid, and other members by radiation, convection, heat transfer, etc., devices with the function of absorbing the heat of heat-transfer sheets, and devices with both the heat-dissipating function and the heat-absorbing function.

### Effects of the Invention

Because the bulk density of the heat-transfer sheet is low, it is easily compressed between a heat generator and a radiator even under relatively low pressure and, hence, comes into close contact with the heat generator and the radiator. Therefore, the thermal resistance between the heat generator and the radiator is small and, hence, the cooling efficiency is high.

Because the recovery of the heat-transfer sheet is high, its bulk density remains below a certain level even after it is used more than once. Therefore, the heat-transfer sheet comes into close contact with a heat generator and a radiator even after it is used more than once, the thermal resistance between the heat generator and the radiator remaining low. Thus, the heat-transfer sheet can be used repeatedly. Because the heat-transfer sheet can be used repeatedly, it contributes toward resources saving.

Because the bulk density of the heat-transfer sheet is low, it is easily compressed between a heat generator and a radiator even under relatively low pressure and, hence, comes into close contact with the heat generator and the radiator. Therefore, the thermal resistance between the heat generator and the radiator is small and, hence, the cooling efficiency is high.

Because its bulk density remains below a certain level even after it is used more than once, it comes into close contact with a heat generator and a radiator even after it is used more than once and, hence, the thermal resistance between the heat generator and the radiator remains low. Thus, the heat-transfer sheet can be used repeatedly. Besides, the force securing a radiator to a heat generator, or the pressure applied to a heat-transfer sheet therebetween, can be reduced compared with the pressure which has been applied to heat-transfer sheets so far; therefore, the load stress on the heat generator is reduced and, hence, damage to the heat generator is prevented.

### Brief Description of Drawings

Fig. 1 (A) is an illustration of an example of how to use the heat-transfer sheet of the present invention. Fig. 1 (B) shows temperature-measuring points "A" and "B."
Fig. 2 (A) shows the relations between the bulk density and the compressibility/recovery of the heat-transfer sheet 1 of Fig. 1 when it was thicknesswise compressed by the pressure of 34.3 MPa. Fig. 2 (B) shows the relation between the compressibility and the recovery.
Fig. 3 shows the relation between the pressure thicknesswise applied to the heat-transfer sheet of Fig. 1 and its thermal conductivity. The bulk density of the heat-transfer sheet was varied.
Fig. 4 (A) shows the relation between the bulk density and the thermal conductivity of the heat-transfer sheet of Fig. 1 under constant pressure. Fig. 4 (B) shows the relation between the number of times of compression and the thermal conductivity.

### Best Mode for carrying out the Invention

Preferred embodiments of the present invention will be described below by referring to drawings.

The heat-transfer sheet of the present invention is used to cool such heat generators as CPUs of computers, printed circuit boards of mobile phones, DVD recorders, and servers. The heat-transfer sheet is put between a heat generator and a radiator such as a head sink or a cooling fan. The thermal resistance of the heat-transfer sheet is small when it is caught and compressed between a heat generator and a radiator. Namely, the thermal conductivity of the heat-transfer sheet is high when it is caught and compressed between a heat generator and a radiator.

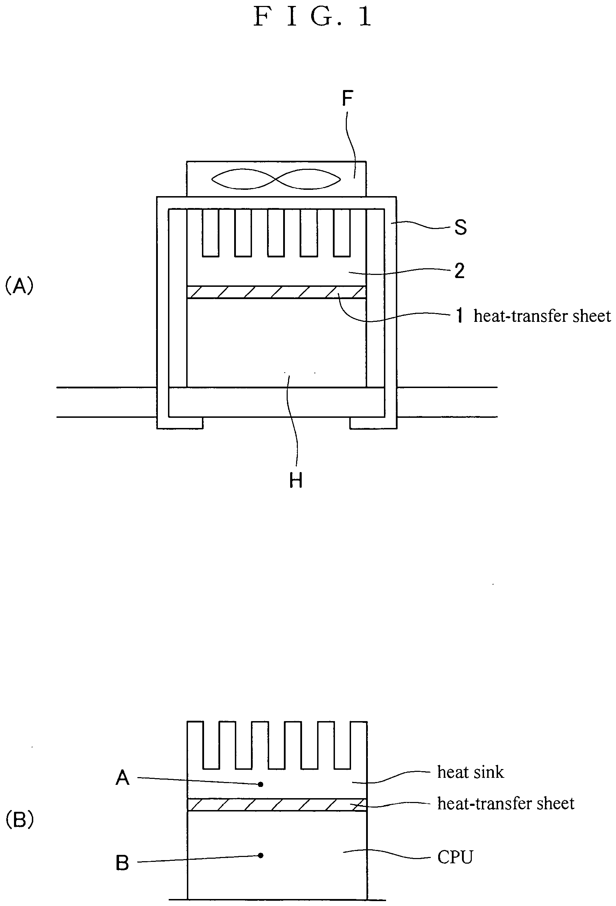

Thermal resistance is the temperature difference between two points separate from each other of a member which is fed with heat from a heat generator divided by the heat-generation rate of the heat generator. In Fig. 1 (B), the thermal resistance is as follows.

The heat-transfer sheet of the present invention is a sheet of expanded graphite which is made by soaking natural or kish graphite in a liquid such as sulfuric or nitric acid and then heat-treating the graphite over 400 °C. Its thickness is 0.05-5.0 mm and its bulk density is less than 0.9

The expanded graphite is fibrous or caterpillar-like. The expanded-graphite fibers are, for example, 1.0 mm or so in length and 300 µm or so in diameter and entangled.

The heat-transfer sheet of the present invention may be made of expanded graphite containing a certain amount (for example, 5% or so) of binder such as phenol resin or rubber.

Any processes for making the heat-transfer sheet of the present invention of the above expanded graphite may be adopted.

As the bulk density of expanded-graphite sheets made of such expanded graphite as described above increases, their thermal conductivity of parallel to surface increases and their flexibility decreases. Accordingly, their bulk density is adjusted in accordance with their uses. Expanded-graphite sheets used as heat-transfer sheets are usually given high bulk density (for example, 1.3 Mg/m³ or more) for high thermal conductivity. Expanded-graphite sheets used as heat-insulating sheets and electromagnetic-wave shielding sheets for walls, etc. are usually given low bulk density (for example, 1.0 Mg/m³ or less).

In the case of the heat-transfer sheet of the present invention, more importance is given to flexibility than to thermal conductivity. The heat-transfer sheet of the present invention is an expanded-graphite sheet which has bulk density less than 0.9

Mg/m³ and is used as heat-insulating sheets and electromagnetic-wave shielding sheets. If an expanded-graphite sheet is given a bulk density of 1.0 Mg/m³ or more, its flexibility is low and it does not come into close contact with a heat generator or a radiator. Accordingly, the expanded-graphite sheet of the present invention is given a bulk density less than 0.9 Mg/m³ so that it will come

into close contact with a heat generator and a radiator as described later. Next, how to use the heat-transfer sheet of the present invention will be described.

Fig. 1 (A) is an illustration of an example of how to use the heat-transfer sheet of the present invention. Fig. 1 (B) shows temperature-measuring points "A" and "B." The reference sign "H" is a heat generator such as a CPU of a computer; reference sign 2, a radiator such as a heat sink; reference sign "F," a cooling fan attached to the heat sink 2.

As shown in Fig. 1, the heat-transfer sheet 1 of this invention is caught between the heat generator "H" and the heat sink 2. When the heat sink 2 is secured to the heat generator "H" with a fixing part "S" such as a clamp, the heat-transfer sheet 1 is squeezed between the heat generator "H" and the heat sink 2.

Because the bulk density of the heat-transfer sheet 1 is less than 0.9 Mg/m³, it is compressed between the heat generator "H" and the heat sink 2 when pressure is applied to it. Accordingly, as the heat-transfer sheet 1 is compressed, it comes into close contact with the heat generator "H" and the heat sink 2. The reason for it is that because the bulk density of the heat-transfer sheet 1 is low and there are spaces between graphite fibers, graphite fibers at the surfaces of the heat-transfer sheet 1 enter concave areas, or recesses, in the surfaces of the heat generator "H" and the heat sink 2. Accordingly, both the thermal resistance between the heat generator "H" and the heat-transfer sheet 1 and that between the heat-transfer sheet 1 and the heat sink 2 decrease. Because the bulk density of the heat-transfer sheet 1 is less than 0.9

Mg/m³ and its thermal conductivity of perpendicular to surface is about 5 W/m·k, the thermal resistance between the heat generator "H" and the heat sink 2 is small and, thus, the thermal conductivity therebetween is high. Thus, the heat generator "H" is efficiently cooled down by the heat-transfer sheet 1 and the heat sink 2.

Besides, because the thermal conductivity in a direction parallel to the surface of the heat-transfer sheet 1 is about 50-200 W/m·k which is larger than its thermal conductivity in a direction perpendicular to the surface, its temperature distribution in the direction parallel to the surface is even; therefore, heat spots do not form on the surfaces of the heat-transfer sheet 1, heat generator "H," or heat sink 2.

Moreover, because the heat-transfer sheet 1 is simply caught between the heat generator "H" and the heat sink 2, it can be replaced with a new one easily. The heat generator "H" is fitted with the radiator as follows.

The heat-transfer sheet 1 is first put on the heat generator "H" and, then, the heat sink 2 is put on the heat-transfer sheet 1. Next, the heat generator "H," heat-transfer sheet 1, and heat sink 2 are caught between a clamp "S" and a printed circuit board if the heat generator "H" is a CPU. Thus, the heat generator "H" is fitted with the radiator.

The heat sink 2 may be fitted with a cooling fan "F" for larger cooling capacity, the heat transfer system then being constituted by the heat-transfer sheet 1, heat sink 2, and cooling fan "F."

Alternatively, the radiator may be constituted by a heat-transfer sheet 1 and a heat-dissipating component such as a cooling fan "F" or a heat absorbing component such as a cooling-water jacket.

If the heat-transfer sheet 1 designed to have a compressibility of 50% or more and a recovery of 5% or more when it is thicknesswise compressed by a pressure of 34.3 MPa for the first time, its bulk density remains less than

Mg/m³ after it is compressed more than one time and the last pressure is removed. Accordingly, even after the heat-transfer sheet 1 is used more than one time, it comes into close contact with the heat generator "H" and the heat sink 2 when it is compressed therebetween. Therefore, the thermal resistance between the heat generator "H" and the heat sink 2 remains low even after the heat-transfer sheet 1 is used more than one time. Thus, the heat-transfer sheet 1 can be used repeatedly.

Particularly if the heat-transfer sheet 1 designed to have a compressibility of 55% or more and a recovery of 6% or more when it is thicknesswise compressed by a pressure of 34.3 MPa for the first time, its bulk density remains more certainly less than 0.9 Mg/m³, after it is compressed more than one time and the last pressure is removed. Accordingly, the heat-transfer sheet 1 can be used more repeatedly.

If the compressibility of the heat-transfer sheet 1 is less than 50% when it is thicknesswise compressed by a pressure of 34.3 MPa for the first time, it is not desirable because the heat-transfer sheet 1 does not come into close contact with the heat generator "H" or the heat sink 2. If the recovery of the heat-transfer sheet 1 is less than 5% when it is thicknesswise compressed by a pressure of 34.3 MPa for the first time, it is not desirable because the heat-transfer sheet 1 does not come into close contact with the heat generator "H" or the heat sink 2 when it is used for the second time and further.

Even though the bulk density of the heat-transfer sheet 1 is less than 0.9 Mg/m³, the bulk density of the heat-transfer sheet 1 after the removal of the pressure may be 0.9 Mg/m³ or more if the pressure is too large when the heat-transfer sheet 1 and the heat sink 2 is secured to the heat generator "H" by a clamp "S." If the heat-transfer sheet 1 is compressed by a pressure over

MPa, the heat generator "H" is exposed to large load stress and the repetitive usability of the heat-transfer sheet 1 is reduced.

Therefore, if the heat generator "H" is fitted with the heat-transfer sheet 1 and the heat sink 2 so as to apply a pressure of 1.5 MPa or less to the heat-transfer sheet 1, the bulk density of the heat-transfer sheet 1 is less than 0.9

Mg/m³ after the removal of the pressure. Therefore, the heat-transfer sheet 1 can be used repeatedly and no damage is done to the heat generator "H."

If the heat-transfer sheet 1 is designed to have a bulk density 0.9 Mg/m³ or less and the heat generator "H" is fitted with the heat-transfer sheet 1 and the heat sink 2 so as to apply a pressure of 1.5 MPa or less to the heat-transfer sheet 1, the bulk density of the heat-transfer sheet 1 is 0.9 Mg/m³ or less after the removal of the pressure. Therefore, the heat-transfer sheet 1 can be used repeatedly and comes into closer contact with the heat generator "H" and the heat sink 2, and the thermal resistance between the heat generator "H" and the heat sink 2 is small.

Particularly if the heat-transfer sheet 1 is designed to have bulk density 0.8 Mg/m³ or less and the heat generator "H" is fitted with the heat-transfer sheet 1 and the heat sink 2 so as to apply a pressure of 0.9 MPa or less to the heat-transfer sheet 1, the bulk density of the heat-transfer sheet 1 is 0.8 Mg/m³ of less after the removal of the pressure. Therefore, the heat-transfer sheet 1 comes into even closer contact with the heat generator "H" and the heat sink 2 and has enough recovery.

If the heat-transfer sheet 1 is treated so as to reduce the impurities in it, such as sulfur and iron, to 10 ppm or less, particularly reduce sulfur to 1 ppm or less, components and devices fitted with the heat-transfer sheet 1 are prevented from deteriorating due to impurities.

### First Embodiment

The compressibility and recovery of the heat-transfer sheet 1 were measured when it was thicknesswise compressed by a pressure of 34.3 MPa.

The bulk density-compressibility relation and the bulk density-recovery relation were ascertained by changing the bulk density of the 0.5-millimeter thick heat-transfer sheet 1 from 0.1 Mg/m³ to 0.5, 0.8, 1.0, 1.2, 1.5 and 1.8 Mg/m³. The compressibility of the heat-transfer sheet 1 was calculated by dividing its thickness under the pressure by its thickness before the compression. The recovery of the heat-transfer sheet 1 was calculated by dividing its thickness after the removal of the pressure by its thickness before the compression.

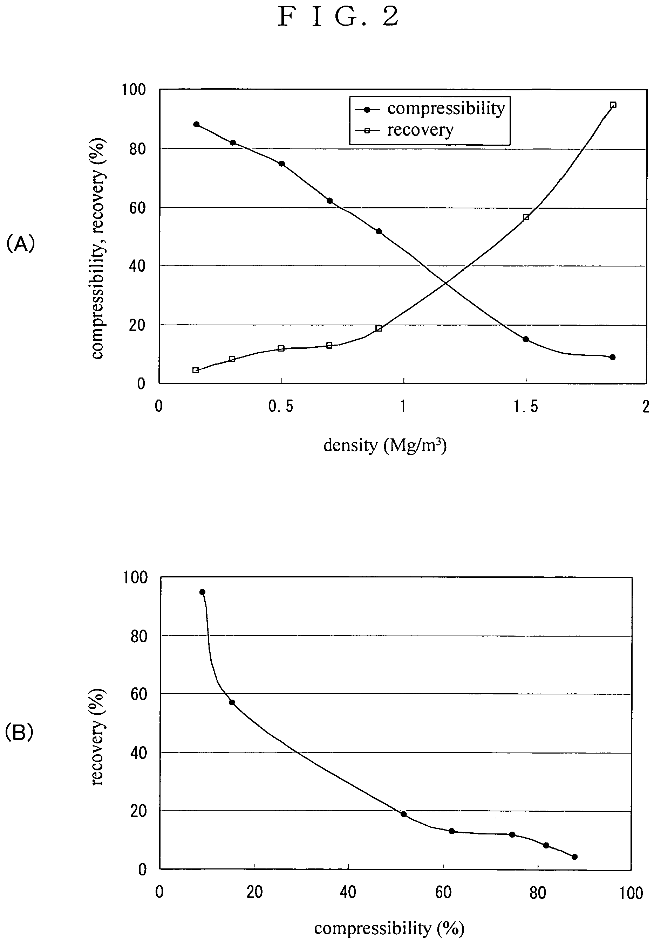

As shown in Fig. 2 (A), as the bulk density increases, the compressibility decreases and the recovery increases.

By and large, as the compressibility increases, the recovery decreases. In the compressibility range over 50%, the slope of recovery is gentle. Particularly in the compressibility range from 55% to 75%, the recovery changes little.

Thus, if the bulk density of the heat-transfer sheet 1 is such that the compressibility is 50% or more, particularly 55-75%, namely, the bulk density is less than 0.9 Mg/m³ [see Fig. 2 (A)], the compressibility is high and the recovery is kept in a certain range.

### Second Embodiment

To ascertain the relation between the thermal conductivity of the heat-transfer sheet 1 and the thicknesswise pressure applied to it, it was put between a CPU (Intel's Celeron Processor 2 GHz) and a heat sink (Intel's aluminium heat sink for Celeron) and the CPU was run at a constant processing speed. And the difference between the temperature in the CPU and the temperature of the heat sink was measured.

As shown in Fig. 1 (B), the distance between the measuring point "A" on the heat sink and the measuring point "B" in the CPU was 20 mm.

Four heat-transfer sheets 1 of the same thickness of 0.5 mm and different bulk densities of 0.1, 0.5, 0.8, and 1.0 Mg/m³ were prepared, and the pressure (pressure pressing down the heat sink to the CPU) was varied from 0.1 MPa to 0.5, 1.0, 2.0, and 5.0 MPa.

Small temperature difference means high thermal conductivity, or small thermal resistance, of the heat-transfer sheet 1. Large temperature difference means low thermal conductivity, or large thermal resistance, of the heat-transfer sheet 1.

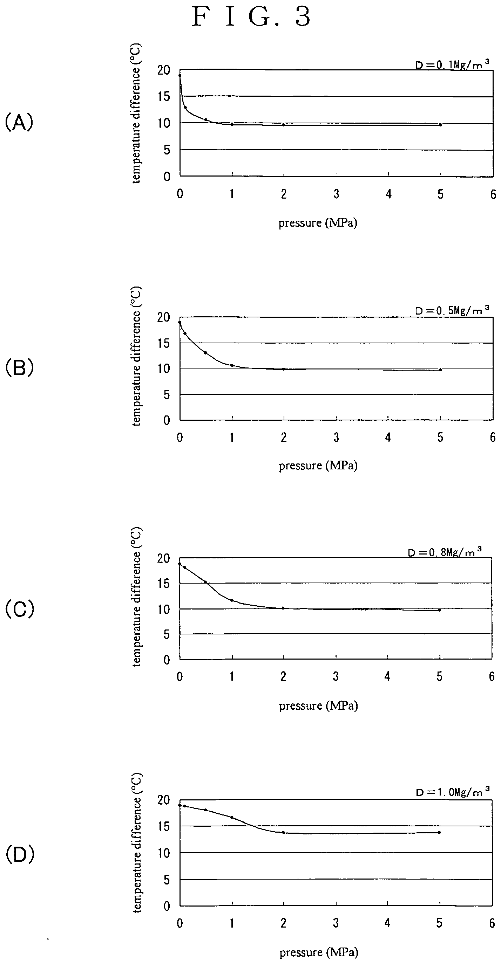

As shown in Fig. 3, the temperature difference shows a tendency to decrease as the pressure increases in any of the four cases of different bulk densities. It is also shown in Fig. 3 that temperature difference becomes constant when the pressure goes beyond a certain level in any cases. Namely, raising the pressure beyond such a certain level does not reduce the temperature difference any more.

It is also shown in Fig. 3 that as the bulk density lowers, such a certain level lowers and that temperature difference is almost constant in the pressure range over 2.0 MPa in any cases of different bulk densities.

It is further shown in Fig. 3 that the temperature difference is almost constant in the pressure range over 1.0 MPa, particularly in the range over 1.5 MPa, if the bulk density is 0.8 Mg/m³ or less.

### Third Embodiment

The relation between the bulk density and the thermal conductivity of the heat-transfer sheet 1 of the present invention under a certain level of pressure was ascertained. Fig. 1 (B) shows the temperature measuring points "A" on a heat think and "B" in a CPU, the distance between the two points being 20 mm.

Seven 0.5-mm thick heat-transfer sheets 1 were prepared so that their respective bulk densities would be 0.1, 0.5, 0.8, 1.0, 1.2, 1.8, and 2.0 Mg/m³ when they were put between the CPU and the heat sink and a pressure of 1.0 MPa was applied to them. Under the conditions, the temperature difference between the two measuring points "A" and "B" was measured.

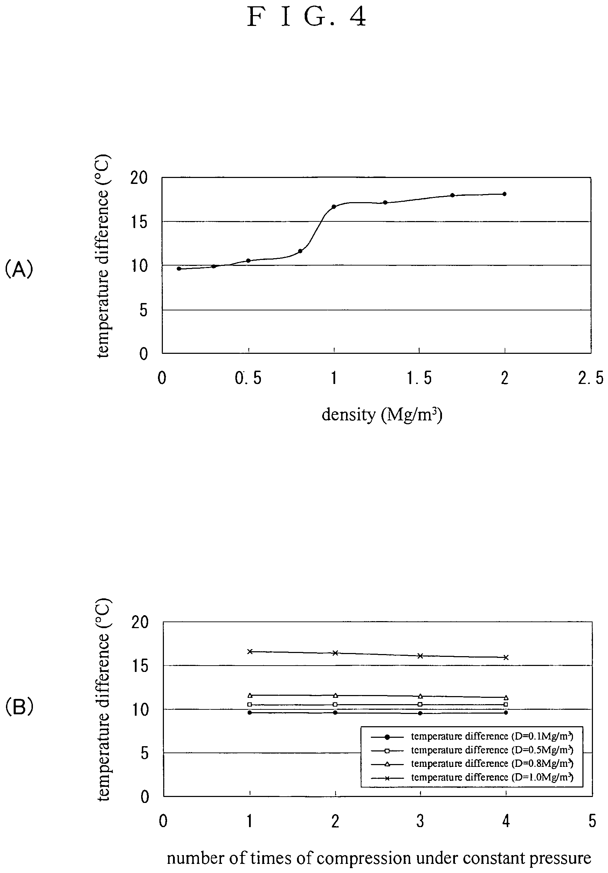

As shown in Fig. 4 (A), as the bulk density increases from 0.1 Mg/m³ to 0.8 Mg/m³, the temperature difference increases very little, but as the bulk density increases from 0.8 Mg/m³ to 1.0 Mg/m³, the temperature difference increases very much. Namely, it is shown in Fig. 3 that if the pressure is about 1.0 MPa, the thermal conductivity of the heat-transfer sheet 1 changes greatly in the bulk-density range from 0.8 to 1.0 Mg/m³.

The comparison between the result of this embodiment and that of the second embodiment suggests that the bulk-density range where the thermal conductivity changes greatly lowers if the pressure lowers below 1.0 MPa, while the range does not change very much if the pressure rises beyond 1.0 MPa.

### Fourth Embodiment

It was ascertained whether the relation between the bulk density and the thermal conductivity of the heat-transfer sheet 1 of the present invention changed or not depending on the number of times of compression under constant pressure. Fig. 1 (B) shows the temperature measuring points "A" on a heat think and "B" in a CPU, the distance between the two points being 20 mm.

Four heat-transfer sheets 1 of the same thickness of 0.5 mm and different bulk densities of 0.1, 0.5, 0.8, and 1.0 Mg/m³ were prepared. Each heat-transfer sheet 1 was compressed between the CPU and the heat sink four times.

As shown in Fig. 4 (B), the temperature difference is constant regardless of the number of times of compression in any case of the four heat-transfer sheets 1 of different bulk densities. Thus, it was ascertained that the thermal conductivity of the heat-transfer sheet 1 was determined by (i) its original bulk density before it was first caught between a CPU and a heat sink and (ii) the pressure applied to it therebetween.

### Industrial Applicability

The heat-transfer sheet of the present invention is suitable for use as a sheet to transfer heat from CPUs of computers, mobile phones, etc., DVD recorders, and so on to radiator such as heat sinks and cooling fans.

## Claims

1. A heat transfer system comprising a heat generator, a heat absorber/dissipator and a heat-transfer sheet whose main material is expanded graphite, and whose bulk density is less than 0.9 Mg/m³, and which is simply caught between the heat generator and the heat absorber/dissipator and is thicknesswise compressed so as to come into close contact with the heat generator and the heat absorber/dissipator wherein the heat-transfer sheet is thicknesswise compressed between the heat generator and the heat absorber/dissipator by a pressure of from 1.0 MPa to 1.5 MPa,
wherein the compressibility of the heat-transfer sheet is 50% or more and wherein the recovery of the heat-transfer sheet is 5% or more when it is thicknesswise compressed by a pressure of 34.3 MPa.

## Patentansprüche

1. Ein Wärmeübertragungssystem mit einem Wärmeerzeuger, einem Wärmeabsorber/Dissipator und einer Wärmeübertragungsplatte, deren Hauptmaterial expandierter Graphit ist und deren Rohdichte weniger als 0,9 Mg/m³ beträgt, und das einfach zwischen dem Wärmeerzeuger und dem Wärmeabsorber/Dissipator eingeklemmt ist und in der Dicke komprimiert ist, um in engen Kontakt mit dem Wärmeerzeuger und dem Wärmeabsorber/Dissipator zu kommen, wobei die Wärmeübertragungsplatte in der Dicke zwischen dem Wärmeerzeuger und dem Wärmeabsorber/Dissipator durch einen Druck von 1,0 MPa bis 1,5 MPa komprimiert ist,
wobei die Komprimierbarkeit der Wärmeübertragungsplatte 50 % oder mehr beträgt und wobei die Rückverformung der Wärmeübertragungsplatte 5 % oder mehr beträgt, wenn sie durch einen Druck von 34,3 MPa in der Dicke komprimiert wird.

## Revendications

1. Système de transfert de chaleur comprenant un générateur de chaleur, un absorbeur/dissipateur de chaleur et une feuille de transfert de chaleur dont le matériau principal est le graphite expansé, et dont la densité apparente est inférieure à 0,9 Mg/m³, et qui est simplement prise entre le générateur de chaleur et l'absorbeur/dissipateur de chaleur et est comprimée dans le sens de l'épaisseur de façon à venir en contact étroit avec le générateur de chaleur et l'absorbeur/dissipateur de chaleur, dans lequel la feuille de transfert de chaleur est comprimée dans le sens de l'épaisseur entre le générateur de chaleur et l'absorbeur/dissipateur de chaleur par une pression de 1,0 MPa à 1,5 MPa,
dans lequel la compressibilité de la feuille de transfert de chaleur est de 50% ou plus et dans lequel la récupération de la feuille de transfert de chaleur est de 5% ou plus lorsqu'elle est comprimée en épaisseur par une pression de 34,3 MPa.
